# EUROPEAN PATENT APPLICATION

(11) **EP 4 322 203 A1**
(43) Date of publication of application: **14.02.2024**
(21) Application number: 22790199.8
(22) Date of filing: 02.08.2022
(51) Int. Cl.: H01L 21/768, H10B 12/00

(54) **METHOD FOR MANUFACTURING SEMICONDUCTOR STRUCTURE**

(30) Priority: 30.06.2022 CN 202210761057
(71) Applicant: Changxin Memory Technologies, Inc., Hefei, Anhui 230601 (CN)
(72) Inventor: LIU, Youming, Hefei City, Anhui 230601 (CN)
(74) Representative: V.O.
(86) International application number: PCT/CN2022/109571
(87) International publication number: WO 2024/000726

(57) **Abstract**

Embodiments of the disclosure relate to a method for manufacturing a semiconductor structure, including the following operations. A structure to be etched is provided. An etched hole is formed in the structure to be etched. Multiple conducting material layer deposition processes are performed until the conducting material layer fills up the etched hole without a void. The method further includes annealing the deposited conducting material layer after at least some of the conducting material layer deposition processes. In the above-mentioned method for manufacturing a semiconductor structure, when the conducting material layer is deposited to fill the etched hole, the etched hole is filled up by performing the multiple conducting material layer deposition processes instead of one-time deposition process, and the deposited conducting material layer is annealed after at least some of the conducting material layer deposition processes, so that the conducting material layer fills up the etched hole without a void.

## Description

### CROSS-REFERENCE TO RELATED APPLICATION

Embodiments of the disclosure claim priority to Chinese Patent Application No. 202210761057.8 filed before the China National Intellectual Property Administration on June 30, 2022, the disclosure of which is incorporated into the embodiments of the disclosure by reference in its entirety.

### TECHNICAL FIELD

Embodiments of the disclosure relate to the field of semiconductor technologies, and in particular to a method for manufacturing a semiconductor structure.

### BACKGROUND

With the development of semiconductor technologies, a size of a semiconductor structure is smaller and smaller, and a depth-to-width ratio of an etched hole of the semiconductor structure will be higher and higher. When a conducting material layer is filled in the etched hole by one-time depositing to form a conducting contact structure, it is prone to form a void in the conducting contact structure, thereby affecting a contact resistance of the conducting contact structure, and even a yield of semiconductor devices.

### SUMMARY

According to various embodiments of embodiments of the disclosure, there is provided a method for manufacturing a semiconductor structure.

According to some embodiments, a first aspect of the disclosure provides a method for manufacturing a semiconductor structure, which includes the following operations.

A structure to be etched is provided.

An etched hole is formed in the structure to be etched.

Multiple conducting material layer deposition processes are performed until the conducting material layer fills up the etched hole without a void. The method further includes annealing the deposited conducting material layer after at least some of the conducting material layer deposition processes.

According to some embodiments, the method further includes annealing the deposited conducting material layer after each of the conducting material layer deposition processes.

According to some embodiments, after annealing the deposited conducting material layer, part of the conducting material layer located at a top corner of a sidewall of the etched hole presents a rounded corner shape.

According to some embodiments, the structure to be etched includes a substrate. The etched hole includes a bit line contact hole. A bit line contact structure is formed after the conducting material layer fills up the etched hole without a void.

According to some embodiments, annealing the deposited conducting material layer after at least some of the conducting material layer deposition processes includes the following operation.

The deposited conducting material layer is annealed after an odd-numbered conducting material layer deposition process, or the deposited conducting material layer is annealed after an even-numbered conducting material layer deposition process.

According to some embodiments, during performing the multiple conducting material layer deposition processes, the number of times of annealing the deposited conducting material layer is more than or equal to half of the number of times of depositing the conducting material layer.

According to some embodiments, the structure to be etched includes a substrate and a dielectric layer located on the substrate. The etched hole penetrates through the dielectric layer in a thickness direction. A capacitor storage node contact structure is formed after the conducting material layer fills up the etched hole without a void.

According to some embodiments, the conducting material layer include a doped polycrystalline silicon layer.

According to some embodiments, a depth-to-width ratio of the etched hole is greater than or equal to 4: 1.

According to some embodiments, the conducting material layer is annealed under an atmosphere including hydrogen.

According to some embodiments, the conducting material layer is annealed under an atmosphere of pure hydrogen.

According to some embodiments, the conducting material layer is annealed under an atmosphere of mixed hydrogen and nitrogen.

According to some embodiments, an annealing temperature includes 700 °C to 1200 °C.

According to some embodiments, an annealing time includes 30s to 2h.

According to some embodiments, an annealing pressure during the annealing includes 10Torr to 760Torr.

According to some embodiments, during annealing the conducting material layer under the atmosphere including hydrogen, a gas flow rate of hydrogen is 1slm to100slm.

The embodiments of the disclosure may/at least have the following advantages.

In the method for manufacturing a semiconductor structure of the embodiments of the disclosure, when the conducting material layer is deposited to fill the etched hole, the etched hole is filled up by performing the multiple conducting material layer deposition processes instead of one-time deposition process, and the deposited conducting material layer is annealed after at least some of the conducting material layer deposition processes, so that the conducting material layer fills up the etched hole without a void.

Details of one or more embodiments of the embodiments of the disclosure are set forth in the accompanying drawings and the description below. Other features, objectives, and advantages of the embodiments of the disclosure will become apparent from the specification, drawings, and claims.

### BRIEF DESCRIPTION OF THE DRAWINGS

In order to more clearly illustrate the technical solutions of the embodiments of this disclosure, the drawings to be used in the description of the embodiments will be briefly introduced below. It is apparent that the drawings in the following description are only some embodiments of this disclosure, and for an ordinary person skilled in the art, other drawings of embodiments can be obtained according to these drawings without making creative efforts.
FIG. 1 is a flowchart of a method for manufacturing a semiconductor structure provided by embodiments of the disclosure;
FIG. 2 is a flowchart of a method for manufacturing a semiconductor structure provided by another embodiments of the disclosure;
FIG. 3 to FIG. 9 are schematic cross-sectional structural diagrams of structures obtained in steps of a method for manufacturing a semiconductor structure provided by another embodiments of the disclosure;
FIG. 10 is a flowchart of a method for manufacturing a semiconductor structure provided by still another embodiments of the disclosure;
FIG. 11 to FIG. 17 are schematic cross-sectional structural diagrams of structures obtained in steps of a method for manufacturing a semiconductor structure provided by still another embodiments of the disclosure;
FIG. 18 is a flowchart of a method for manufacturing a storage device structure provided by still another embodiments of the disclosure; and
FIG. 19 to FIG. 30 are schematic cross-sectional structural diagrams of structures obtained in steps of a method for manufacturing a storage device structure provided by still another embodiments of the disclosure.

### DETAILED DESCRIPTION

In order to facilitate understanding of embodiments of the disclosure, the embodiments of the disclosure will be described more comprehensively hereinafter with reference to the corresponding drawings. Embodiments of the disclosure are shown in the drawings. However the embodiments of the disclosure can be implemented in many different forms and is not limited to the embodiments described herein. In contrast, these embodiments are provided to make the disclosure of the embodiments of the disclosure more thorough and comprehensive.

Unless otherwise defined, all technical and scientific terms used herein have the same meaning as commonly understood by one person skilled in the art to which the embodiments of the disclosure belong. Terms used herein in the specification of the embodiments of the disclosure are for the purpose of describing specific embodiments only and are not intended to limit the embodiments of the disclosure.

It should be understood that although terms "first", "second" and the like used in the embodiments of the disclosure may be used to describe various elements, these elements should not be limited by these terms. These terms are only used to distinguish a first element from another element. For example, without departing from the scope of the embodiments of the disclosure, an input end of a first power may be referred to as an input end of a second power, and similarly, the input end of the second power may also be referred to as the input end of the first power. Both the input end of the first power and the input end of the second power are power input ends, but they are not the same power input end.

It can be understood that, "connection" in the following embodiments should be understood as "electrical connection", "communication connection", or the like if there are electrical signals or data transmission between each other of connected circuits, modules, units, or the like.

As used here, singular forms "a", "an" and "said/the" can also include plural forms, unless otherwise clearly indicated in the context. It should also be understood that the terms "including/comprising" or "having" and the like designate the presence of a stated feature, integer, step, operation, component, part, or a combination thereof, but do not exclude the possibility of the presence or addition of one or more other features, integers, steps, operations, components, parts, or a combination thereof.

With the development of semiconductor technologies, a size of a semiconductor structure is smaller and smaller, and a depth-to-width ratio of an etched hole of the semiconductor structure will be higher and higher. When a conducting material layer is filled in the etched hole by depositing to form a conducting contact structure, it is prone to form a void in the conducting contact structure, thereby affecting a contact resistance between the conducting contact structure and other structures, and even a yield of semiconductor structures.

Taking a dynamic random access memory (DRAM) as an example, as a size of the DRAM shrinks, depth-to-width ratios of a contact hole of a bit line (BL) and a contact hole of a capacitor storage node in an array area are getting higher and higher. When a conducting material layer is deposited in a contact hole by one-time deposition process to form a bit line contact structure (BLC, bit line coupling) or a capacitor storage node contact structure, a void is inevitably generated in the bit line contact structure or the capacitor storage node contact structure, which affects a contact resistance of the bit line contact structure or the capacitor storage node contact structure, and even affects a yield of semiconductor device structures.

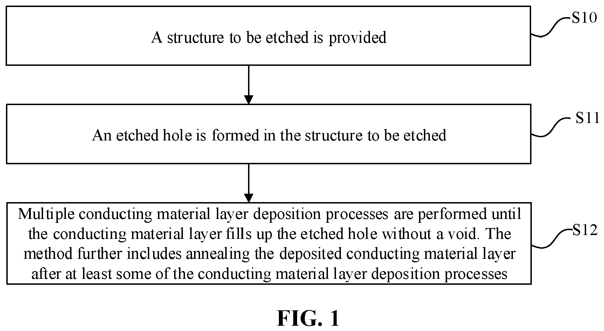

Referring to FIG. 1, embodiments of the disclosure provide a method for manufacturing a semiconductor structure, which includes the following operations.

At S 10, a structure to be etched is provided.

At S11, an etched hole is formed in the structure to be etched.

At S12, multiple conducting material layer deposition processes are performed until the conducting material layer fills up the etched hole without a void. The method further includes annealing the deposited conducting material layer after at least some of the conducting material layer deposition processes.

In the above-mentioned method for manufacturing a semiconductor structure, when the conducting material layer is deposited to fill the etched hole, the etched hole is filled up by performing the multiple conducting material layer deposition processes instead of one-time deposition process, and the deposited conducting material layer is annealed after at least some of the conducting material layer deposition processes, so that the conducting material layer fills up the etched hole without a void.

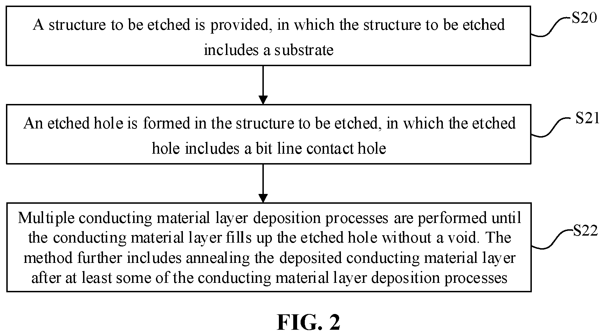

In an embodiment, the structure to be etched includes a substrate. In the embodiment, as shown in FIG. 2, the method for manufacturing a semiconductor structure may include the following operations.

At S20, a structure to be etched is provided, in which the structure to be etched includes a substrate.

At S21, an etched hole is formed in the structure to be etched, in which the etched hole includes a bit line contact hole.

At S22, multiple conducting material layer deposition processes are performed until the conducting material layer fills up the etched hole without a void. The method further includes annealing the deposited conducting material layer after at least some of the conducting material layer deposition processes.

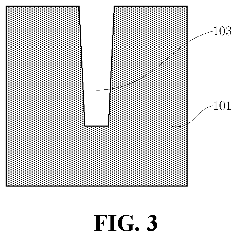

At S20, referring to S20 of FIG. 2 and FIG. 3, a structure to be etched is provided, in which the structure to be etched includes a substrate 101.

In an example, the substrate 101 may include, but is not limited to, a silicon substrate.

At S21, referring to S21 of FIG. 2 and FIG. 3, an etched hole is formed in the structure to be etched, in which the etched hole includes a bit line contact hole 103.

In an example, the bit line contact hole 103 may be formed in the substrate 101 by adopting a photolithography etching process. A shape of a longitudinal section of the bit line contact hole 103 can be set according to actual requirements. The shape of the longitudinal section of the bit line contact hole 103 may an inverted trapezoid, a rectangle or a U shape or the like. In the embodiment, the shape of the longitudinal section of the bit line contact hole 103 is an inverted trapezoid, as shown in FIG. 3.

It should be noted that a depth of the bit line contact hole 103 is less than a depth of the substrate 101.

In an example, a depth-to-width ratio of the bit line contact hole 103 can be set according to actual requirements. In the embodiment, the depth-to-width ratio of the bit line contact hole 103 may be greater than or equal to 4:1, for example, 4:1, 5:1, 10:1, 15:1, 20:1, or the like.

At S22, referring to S22 of FIG. 2 and FIG. 4 to FIG. 8, multiple conducting material layer 11 deposition processes are performed until the conducting material layer 11 fills up the etched hole without a void. The method further includes annealing the deposited conducting material layer 11 after at least some of the conducting material layer 11 deposition processes.

In an example, the deposited conducting material layer 11 may be annealed after part of the deposition processes.

In an optional example, the deposited conducting material layer 11 may be annealed after an odd-numbered conducting material layer 11 deposition process. In another optional example, the deposited conducting material layer 11 may be annealed after an even-numbered conducting material layer deposition process. Of course, in other examples, the deposited conducting material layer 11 may be annealed according to actual requirements after any part of the conducting material layer 11 deposition processes.

It should be noted that, during performing the multiple conducting material layer deposition processes, the number of times of annealing the deposited conducting material layer 11 is more than or equal to half of the number of times of depositing the conducting material layer 11. For example, the number of times of depositing the conducting material layer 11 is 10 times, and the number of times of annealing the deposited conducting material layer 11 should be more than 5 times, that is, a corresponding annealing is required after each of the more than 5 times of depositing the conducting material layer 11.

In another example, the method further includes annealing the deposited conducting material layer 11 after each of the conducting material layer 11 deposition processes. In the example, S22 may include the following operations.

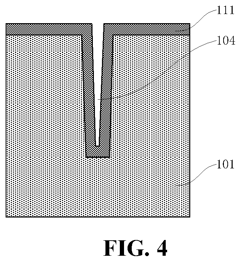

At S221, a first conducting material layer 111 is deposited in the bit line contact hole 103 by adopting a deposition process, as shown in FIG. 4.

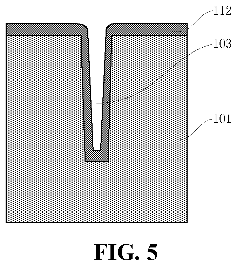

At S222, the first conducting material layer 111 is annealed, and a first conducting layer 112 is obtained after annealing, as shown in FIG. 5.

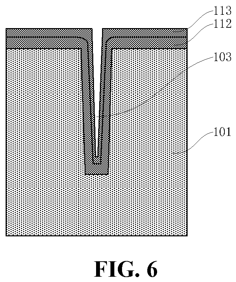

At S223, a second conducting material layer 113 is formed on a top surface of the first conducting layer 112 by adopting a deposition process, as shown in FIG. 6.

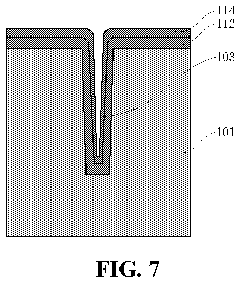

At S224, the second conducting material layer 113 is annealed, and a second conducting layer 114 is obtained after annealing, as shown in FIG. 7.

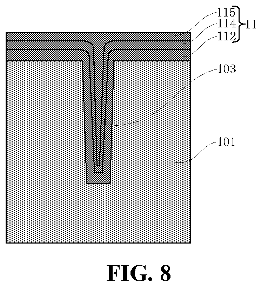

At S225, an Nth conducting material layer 115 is filled in the bit line contact hole 103 by adopting a deposition process. The Nth conducting material layer 115 fills up the bit line contact hole 103, as shown in FIG. 8. N is an integer greater than or equal to 3.

It should be noted that, when N is an integer greater than 3, a certain number of operations of depositing corresponding conducting material layers and annealing the deposited conducting material layers are further included between S224 and S225. N=3 is taken as an example in FIG. 8, in other examples, a value of N is not limited to this.

At S221, the first conducting material layer 111 may be formed by physical vapor deposition, chemical vapor deposition or atomic layer deposition.

At S221, the formed first conducting material layer 111 may include, but is not limited to, a doped polycrystalline silicon layer.

At S222, the first conducting material layer 111 may be annealed under an atmosphere including hydrogen.

In an optional example, the first conducting material layer 111 may be annealed under an atmosphere of pure hydrogen. Specifically, hydrogen can be introduced into an environment where the first conducting material layer 111 is located to form the atmosphere of pure hydrogen. More specifically, in the example, a gas flow rate of hydrogen may be 1slm (standard liter per minute) to 100slm, for example, 1slm, 10slm, 50slm, 100slm, or the like.

In another optional example, the first conducting material layer 111 may be annealed under an atmosphere of mixed hydrogen and nitrogen. Specifically, a mixed gas of hydrogen and nitrogen can be introduced into an environment where the first conducting material layer 111 is located to form the atmosphere of mixed hydrogen and nitrogen. More specifically, in the example, a gas flow rate of hydrogen may be 1slm (standard liter per minute) to 100slm, for example, 1slm, 10slm, 50slm, 100slm, or the like.

At S222, a temperature at which the first conducting material layer 111 is annealed may be 700 °C to 1200 °C. Specifically, the temperature at which the first conducting material layer 111 is annealed may be 700 °C, 800 °C, 900 °C, 1000 °C, 1100°C, 1200 °C, or the like.

At S222, a time for which the first conducting material layer 111 is annealed may be 30s to 2h (hour). Specifically, the time for which the first conducting material layer 111 is annealed may be 30s, 5min (minute), 10min, 30min, 1h, or 2h, or the like.

At S222, a pressure at which the first conducting material layer 111 is annealed may be 10Torr to 760Torr. Specifically, the pressure at which the first conducting material layer 111 is annealed may be 10Torr, 50Torr, 100Torr, 200Torr, 300Torr, 400Torr, 500Torr, 600Torr, 700Torr, or 760Torr, or the like.

At S222, part of the first conducting layer 112, which is obtained after the first conducting material layer 111 is annealed, located at a top corner of a sidewall of the bit line contact hole 103 presents a rounded corner shape, as shown in FIG. 5.

A round corner rate at the corner can be controlled by selecting specifically the above-mentioned gas flow rate, pressure and annealing time. Under a same gas flow rate and the same annealing time, the higher the pressure is, the higher the temperature is, and the larger the round corner rate is. Under a constant pressure and a constant time, the greater the flow rate is, the higher the temperature is, and the larger the round corner rate is. According to different depth-to-width ratios of the bit line contact hole 103 and a different specific thickness of a deposited conducting material layer, requirements for the flow rate, the pressure, the time and the temperature are also different.

At S223, the second conducting material layer 113 may be formed by of physical vapor deposition, chemical vapor deposition or atomic layer deposition.

At S223, the formed second conducting material layer 113 may include, but is not limited to, a doped polycrystalline silicon layer.

At S224, the second conducting material layer 113 may be annealed under an atmosphere including hydrogen.

In an optional example, the second conducting material layer 113 may be annealed under an atmosphere of pure hydrogen. Specifically, hydrogen can be introduced into an environment where the second conducting material layer 113 is located to form the atmosphere of pure hydrogen. More specifically, in the example, a gas flow rate of hydrogen may be 1slm (standard liter per minute) to 100slm, for example, 1slm, 10slm, 50slm, or 100slm, or the like.

In another optional example, the second conducting material layer 113 may be annealed under an atmosphere of mixed hydrogen and nitrogen. Specifically, a mixed gas of hydrogen and nitrogen can be introduced into an environment where the second conducting material layer 113 is located to form the atmosphere of mixed hydrogen and nitrogen. More specifically, in the example, a gas flow rate of hydrogen may be 1slm (standard liter per minute) to 100slm, for example, 1slm, 10slm, 50slm, or 100slm, or the like.

At S224, a temperature at which the second conducting material layer 113 is annealed may be 700 °C to 1200 °C. Specifically, the temperature at which the second conducting material layer 113 is annealed may be 700 °C, 800 °C, 900 °C, 1000 °C, 1100 °C, or 1200 °C, or the like.

At S224, a time for which the second conducting material layer 113 is annealed may be 30s to 2h (hour). Specifically, the time for which the second conducting material layer 113 is annealed may be 30s, 5min (minute), 10min, 30min, 1h, or 2h, or the like.

At S224, a pressure at which the second conducting material layer 113 is annealed may be 10Torr to 760Torr. Specifically, the pressure at which the second conducting material layer 113 is annealed may be 10Torr, 50Torr, 100Torr, 200Torr, 300Torr, 400Torr, 500Torr, 600Torr, 700Torr, or 760Torr, or the like.

At S224, part of the second conducting layer 114, which is obtained after the second conducting material layer 113 is annealed, located at a top corner of a sidewall of the bit line contact hole 103 presents a rounded corner shape, as shown in FIG. 7.

At S225, the Nth conducting material layer 115 may be formed by of physical vapor deposition, chemical vapor deposition or atomic layer deposition.

At S225, the formed Nth conducting material layer 115 may include, but is not limited to, a doped polycrystalline silicon layer.

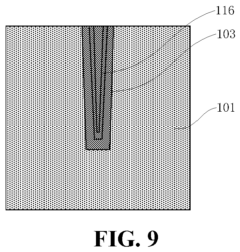

In an example, referring to FIG. 9, the method further include S226, after the Nth conducting material layer 115 is filled in the bit line contact hole 103 by adopting the deposition process at S225.

At S226, the structure obtained at S225 is flattened to remove the first conducting layer 112, the second conducting layer 114 and the Nth conducting material layer 115 which are located on a top surface of the substrate 101, remaining the first conducting layer 112, the second conducting layer 114 and the Nth conducting material layer 115 located in the bit line contact hole 103 to jointly constitute a bit line structure 116.

Specifically, at S226, the structure obtained at S225 is flattened by adopting a Chemical Mechanical Polishing (CMP) process.

In the method for manufacturing a semiconductor structure of the above-mentioned embodiments of the disclosure, when the conducting material layer 11 is deposited to fill the bit line contact hole 103 , the bit line contact hole 103 is filled up by performing the multiple conducting material layer deposition processes instead of one-time deposition process, and the deposited conducting material layer 11 is annealed after at least some of the conducting material layer deposition processes, so that the conducting material layer 11 fills up the bit line contact hole 103 without a void, That is, the bit line contact structure 116 without a void can be obtained, thereby reducing a contact resistance of the bit line contact structure 116 and thus improving a yield of semiconductor device structures.

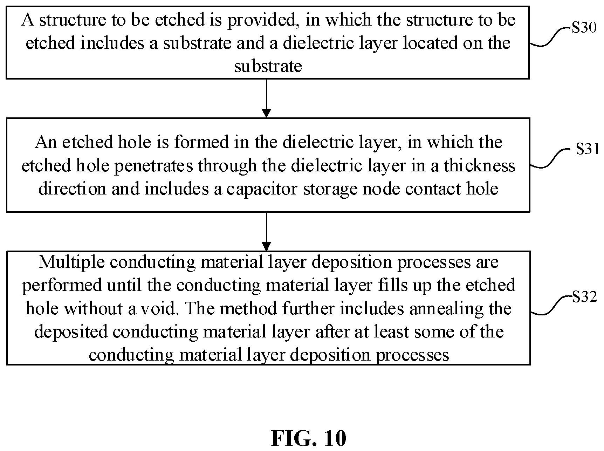

In another embodiment, the structure to be etched includes a substrate and a dielectric layer located on the substrate, and an etched hole penetrates through the dielectric layer in a thickness direction. In the embodiment, as shown in FIG. 10, the method for manufacturing a semiconductor structure may include the following operations.

At S30, a structure to be etched is provided, in which the structure to be etched includes a substrate and a dielectric layer located on the substrate.

At S31, an etched hole is formed in the structure to be etched, in which the etched hole penetrates through the dielectric layer in a thickness direction and includes a capacitor storage node contact hole.

At S32, multiple conducting material layer deposition processes are performed until the conducting material layer fills up the etched hole without a void. The method further includes annealing the deposited conducting material layer after at least some of the conducting material layer deposition processes.

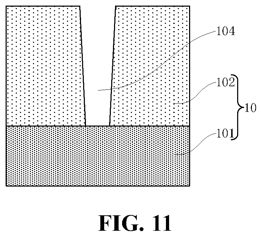

At S30, referring to S30 of FIG. 10 and FIG. 11, a structure to be etched 10 is provided, in which the structure to be etched 10 includes a substrate 101 and a dielectric layer 102 located on the substrate 101.

In an example, the substrate 101 may include, but is not limited to, a silicon substrate, and the dielectric layer 102 may include, but is not limited to, a silicon oxide layer, a silicon nitride layer, a silicon oxynitride layer, or the like.

At S31, referring to S31 of FIG. 10 and FIG. 11, an etched hole is formed in the structure to be etched 10. The etched hole penetrates through the dielectric layer 102 in a thickness direction and includes a capacitor storage node contact hole 104.

In an example, the capacitor storage node contact hole 104 may be formed in the dielectric layer 102 by adopting a photolithography etching process. A shape of a longitudinal section of the capacitor storage node contact hole 104 can be set according to actual requirements. The shape of the longitudinal section of the capacitor storage node contact hole 104 may an inverted trapezoid, a rectangle or a U shape. In the embodiment, the shape of the longitudinal section of the capacitor storage node contact hole 104 is an inverted trapezoid, as shown in FIG. 11.

It should be noted that, a depth of the capacitor storage node contact hole 104 may be greater than a thickness of the dielectric layer 102 and less than a sum of thicknesses of the dielectric layer 102 and the substrate 101, that is, the capacitor storage node contact hole 104 is deep into the substrate 101.

In an example, a depth-to-width ratio of the capacitor storage node contact hole 104 can be set according to actual requirements. In the embodiment, the depth-to-width ratio of the capacitor storage node contact hole 104 may be greater than or equal to 4:1, for example, 4:1, 5:1, 10:1, 15:1, or 20:1, or the like.

At S32, referring to S32 of FIG. 10 and FIG. 12 to FIG. 17, multiple conducting material layer 11 deposition processes are performed until the conducting material layer 11 fills up the etched hole without a void. The method further includes annealing the deposited conducting material layer 11 after at least some of the conducting material layer 11 deposition processes.

In an example, the deposited conducting material layer 11 may be annealed after part of the deposition processes.

In an optional example, the deposited conducting material layer 11 may be annealed after an odd-numbered conducting material layer 11 deposition process. In another optional example, the deposited conducting material layer 11 may be annealed after an even-numbered conducting material layer deposition process. Of course, in other examples, the deposited conducting material layer 11 may be annealed according to actual requirements after any part of the conducting material layer 11 deposition processes.

It should be noted that, during performing the multiple conducting material layer deposition processes, the number of times of annealing the deposited conducting material layer 11 is more than or equal to half of the number of times of depositing the conducting material layer 11. For example, the number of times of depositing the conducting material layer 11 is 10 times, and the number of times of annealing the deposited conducting material layer 11 should be more than 5 times, that is, a corresponding annealing is required after each of more than 5 times of depositing the conducting material layer 11.

In another example, the method further includes annealing the deposited conducting material layer 11 after each of the conducting material layer 11 deposition processes. In the example, S32 may include the following operations.

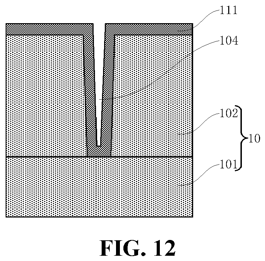

At S321, a first conducting material layer 111 is deposited in the capacitor storage node contact hole 104 by adopting a deposition process, as shown in FIG. 12.

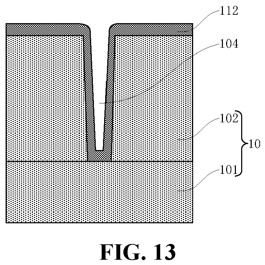

At S322, the first conducting material layer 111 is annealed, and a first conducting layer 112 is obtained after annealing, as shown in FIG. 13.

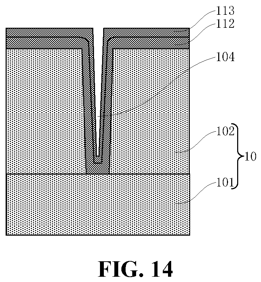

At S323, a second conducting material layer 113 is formed on a top surface of the first conducting layer 112 by adopting a deposition process, as shown in FIG. 14.

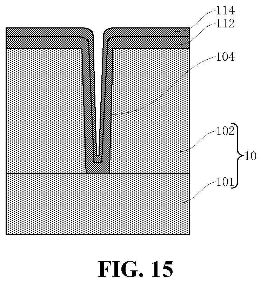

At S324, the second conducting material layer 113 is annealed, and a second conducting layer 113 is obtained after annealing, as shown in FIG. 15.

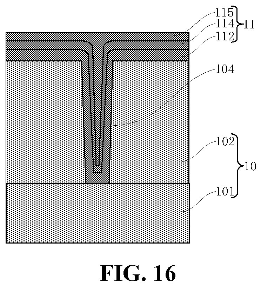

At S325, an Nth conducting material layer 115 is filled in the capacitor storage node contact hole 104 by adopting a deposition process. The Nth conducting material layer 115 fills up the capacitor storage node contact hole 104, as shown in FIG. 16. N is an integer greater than or equal to 3.

It should be noted that, when N is an integer greater than 3, a certain number of operations of depositing corresponding conducting material layers and annealing the deposited conducting material layers are further included between S324 and S325. N=3 is taken as an example in FIG. 16, in other examples, a value of N is not limited to this.

At S321, the first conducting material layer 111 may be formed by physical vapor deposition, chemical vapor deposition or atomic layer deposition or the like.

At S321, the formed first conducting material layer 111 may include, but is not limited to, a doped polycrystalline silicon layer.

At S322, the first conducting material layer 111 may be annealed under an atmosphere including hydrogen.

In an optional example, the first conducting material layer 111 may be annealed under an atmosphere of pure hydrogen. Specifically, hydrogen can be introduced into an environment where the first conducting material layer 111 is located to form the atmosphere of pure hydrogen. More specifically, in the example, a gas flow rate of hydrogen may be 1slm (standard liter per minute) to 100slm, for example, 1slm, 10slm, 50slm, or 100slm, or the like.

In another optional example, the first conducting material layer 111 may be annealed under an atmosphere of mixed hydrogen and nitrogen. Specifically, a mixed gas of hydrogen and nitrogen can be introduced into an environment where the first conducting material layer 111 is located to form the atmosphere of mixed hydrogen and nitrogen. More specifically, in the example, a gas flow rate of hydrogen may be 1slm (standard liter per minute) to 100slm, for example, 1slm, 10slm, 50slm, or 100slm, or the like.

At S322, a temperature at which the first conducting material layer 111 is annealed may be 700 °C to 1200 °C. Specifically, the temperature at which the first conducting material layer 111 is annealed may be 700 °C, 800 °C, 900 °C, 1000 °C, 1100 °C, or 1200 °C, or the like.

At S322, a time for which the first conducting material layer 111 is annealed may be 30s to 2h (hour). Specifically, the time for which the first conducting material layer 111 is annealed may be 30s, 5min (minute), 10min, 30min, 1h, or 2h, or the like.

At S322, a pressure at which the first conducting material layer 111 is annealed may be 10Torr to 760Torr. Specifically, the pressure at which the first conducting material layer 111 is annealed may be 10Torr, 50Torr, 100Torr, 200Torr, 300Torr, 400Torr, 500Torr, 600Torr, 700Torr, or 760Torr, or the like.

At S322, part of the first conducting layer 112, which is obtained after the first conducting material layer 111 is annealed, located at a top corner of a sidewall of the capacitor storage node contact hole 104 presents a rounded corner shape, as shown in FIG. 13.

A round corner rate at the corner can be controlled by selecting specifically the above-mentioned gas flow rate, pressure and annealing time. Under a same gas flow rate and a same annealing time, the higher the pressure is, the higher the temperature is, and the larger the round corner rate is. Under a constant pressure and a constant time, the greater the flow rate is, the higher the temperature is, and the larger the round corner rate is. According to different depth-to-width ratios of the bit line contact hole 103 and a different specific thickness of a deposited conducting material layer, requirements for the flow rate, the pressure, the time and the temperature are also different.

At S323, the second conducting material layer 113 may be formed by physical vapor deposition, chemical vapor deposition or atomic layer deposition or the like.

At S323, the formed second conducting material layer 113 may include, but is not limited to, a doped polycrystalline silicon layer.

At S324, the second conducting material layer 113 may be annealed under an atmosphere including hydrogen.

In an optional example, the second conducting material layer 113 may be annealed under an atmosphere of pure hydrogen. Specifically, hydrogen can be introduced into an environment where the second conducting material layer 113 is located to form the atmosphere of pure hydrogen. More specifically, in the example, a gas flow rate of hydrogen may be 1slm (standard liter per minute) to 100slm, for example, 1slm, 10slm, 50slm, or 100slm, or the like.

In another optional example, the second conducting material layer 113 may be annealed under an atmosphere of mixed hydrogen and nitrogen. Specifically, a mixed gas of hydrogen and nitrogen can be introduced into an environment where the second conducting material layer 113 is located to form the atmosphere of mixed hydrogen and nitrogen. More specifically, in the example, a gas flow rate of hydrogen may be 1slm (standard liter per minute) to 100slm, for example, 1slm, 10slm, 50slm, or 100slm, or the like.

At S324, a temperature at which the second conducting material layer 113 is annealed may be 700 °C to 1200 °C. Specifically, the temperature at which the second conducting material layer 113 is annealed may be 700 °C, 800 °C, 900 °C, 1000 °C, 1100 °C, or 1200 °C, or the like.

At S324, a time for which the second conducting material layer 113 is annealed may be 30s to 2h (hour). Specifically, the time for which the second conducting material layer 113 is annealed may be 30s, 5min (minute), 10min, 30min, 1h, or 2h, or the like.

At S324, a pressure at which the second conducting material layer 113 is annealed may be 10Torr to 760Torr. Specifically, the pressure at which the second conducting material layer 113 is annealed may be 10Torr, 50Torr, 100Torr, 200Torr, 300Torr, 400Torr, 500Torr, 600Torr, 700Torr, or 760Torr, or the like.

At S324, part of the second conducting layer 114, which is obtained after the second conducting material layer 113 is annealed, located at a top corner of a sidewall of the capacitor storage node contact hole 104 presents a rounded corner shape, as shown in FIG. 7.

At S325, the Nth conducting material layer 115 may be formed by of physical vapor deposition, chemical vapor deposition or atomic layer deposition or the like.

At S325, the formed Nth conducting material layer 115 may include, but is not limited to, a doped polycrystalline silicon layer.

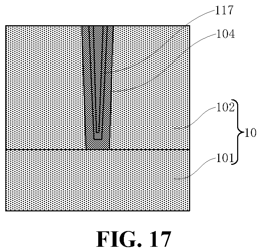

In an example, referring to FIG. 17, the method further include S326 after the Nth conducting material layer 115 is filled in the capacitor storage node contact hole 104 by adopting the deposition process at S325.

At S326, the structure obtained at S325 is flattened to remove the first conducting layer 112, the second conducting layer 114 and the Nth conducting material layer 115 which are located on a top surface of the dielectric layer 102, remaining the first conducting layer 112, the second conducting layer 114 and the Nth conducting material layer 115 located in the capacitor storage node contact hole 104 to jointly constitute a capacitor storage node contact structure 117.

Specifically, at S326, the structure obtained at S325 is flattened by adopting a chemical mechanical polishing (CMP) process.

In the method for manufacturing a semiconductor structure of the above-mentioned embodiments, when the conducting material layer 11 is deposited to fill the capacitor storage node contact hole 104, the capacitor storage node contact hole 104 is filled up by performing the multiple conducting material layer deposition processes instead of one-time deposition process, and the deposited conducting material layer 11 is annealed after at least some of the conducting material layer deposition processes, so that the conducting material layer 11 fills up the capacitor storage node contact hole 104 without a void, That is, the capacitor storage node contact structure 117 without a void can be obtained, thereby reducing a contact resistance of the capacitor storage node contact structure 117 and thus improving a yield of semiconductor device structures.

It should be noted that, in another embodiment, the capacitor storage node contact hole 104 can be replaced by an interconnection contact hole between a metal layer and the substrate, and the finally obtained capacitor storage node contact structure 117 can be replaced by an interconnection contact structure between the metal layer and the substrate. In another embodiment, the substrate 101 can be replaced by a dielectric layer formed with a metal layer. In this case, the capacitor storage node contact hole 104 can also be replaced by an interconnection contact hole between metal layers, and the finally obtained capacitor storage node contact structure 117 can be replaced by an interconnection contact structure between the metal layers.

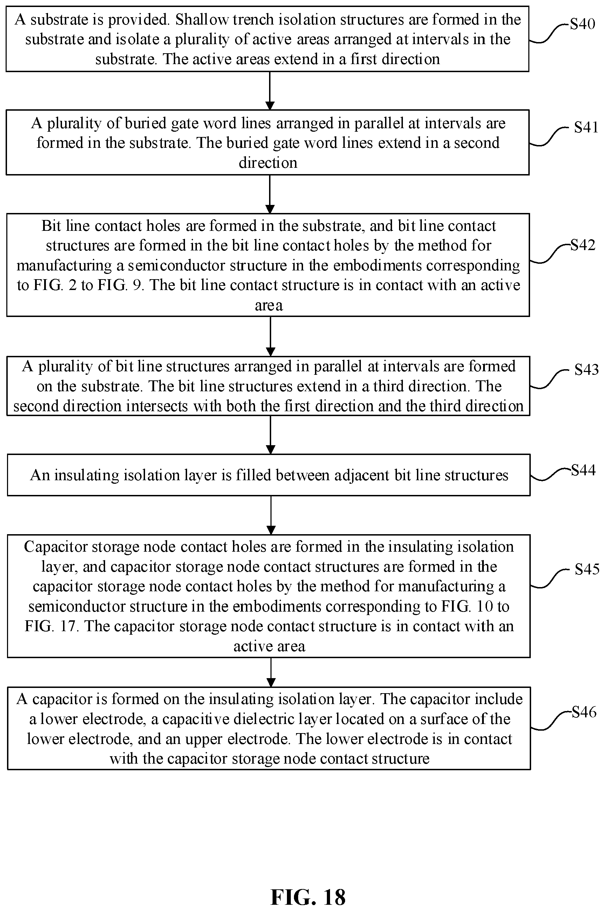

In still another embodiment, referring to FIG. 18, embodiments of the disclosure further provide a method for manufacturing a storage device structure, which includes the following operations.

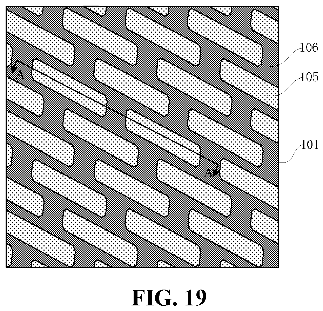

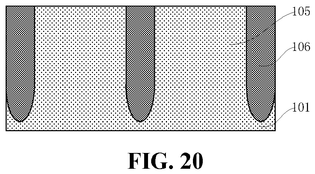

At S40, a substrate 101 is provided, in which shallow trench isolation structures 106 is formed in the substrate 101. The shallow trench isolation structures 106 isolate a plurality of active areas 105 arranged at intervals in the substrate. The active areas 105 extend in a first direction, as shown in FIG. 19 and FIG. 20. FIG. 19 is a schematic top structural diagram of the structure obtained at S40, and FIG. 20 is a schematic cross-sectional structural diagram along an AA direction in FIG.19.

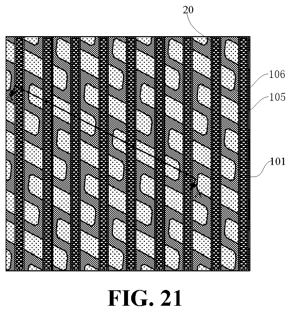

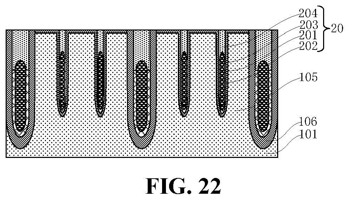

At S41, a plurality of buried gate word lines 20 arranged in parallel at intervals are formed in the substrate 101. Buried gate word lines 20 extend in a second direction, as shown in FIG. 21 and FIG. 22. FIG. 21 is a schematic top structural diagram of the structure obtained at S41, and FIG. 22 is a schematic cross-sectional structural diagram along an AA direction in FIG.21. The buried gate word line 20 may include a gate oxide layer 201, a first gate conducting layer 202, a second gate conducting layer 203 and a filling dielectric layer 204. The gate oxide layer 201 is located on sidewalls and a bottom wall of a gate trench. The first gate conducting layer 202 is located in the gate trench and on a surface of the gate oxide layer 201. The second gate conducting layer 203 is located in the gate trench and on a surface of the first gate conducting layer 202. A top of the first gate conducting layer 202 and a top of the second gate conducting layer 203 are lower than a top of the gate trench. The gate trench is filled up with the filling dielectric layer 204.

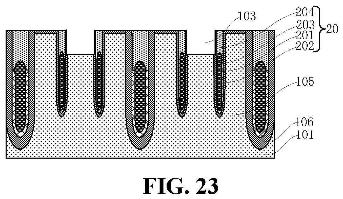

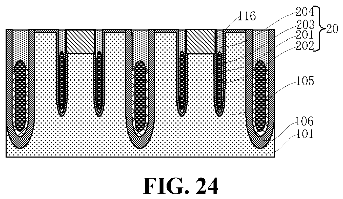

At S42, bit line contact holes 103 are formed in the substrate 101, and bit line contact structures 116 are formed in the bit line contact holes 103 by the method for manufacturing a semiconductor structure in the embodiments corresponding to FIG. 2 to FIG. 9. A bit line contact structure 116 is in contact with an active area, as shown in FIG. 23 and FIG. 24.

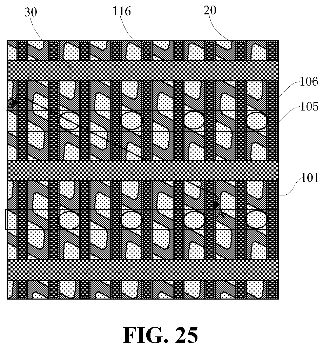

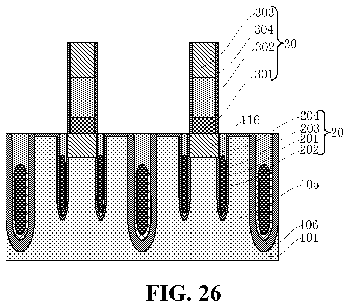

At S43, a plurality of bit line structures 30 arranged in parallel at intervals are formed on the substrate 101, in which bit line structures 30 extend in a third direction. The second direction intersects with both the first direction and the third direction, as shown in FIG. 25 and FIG. 26. FIG. 25 is a schematic top structural diagram of the structure obtained at S43, and FIG. 26 is a schematic cross-sectional structural diagram along an AA direction in FIG.25. The bit line structure 30 may include a stacked structure constituted by a first bit line conducting layer 301, a second bit line conducting layer 302 and a bit line dielectric layer stacked in sequence from bottom to up, and bit line sidewalls 304 located on sidewalls of the stacked structure, as shown in FIG. 26.

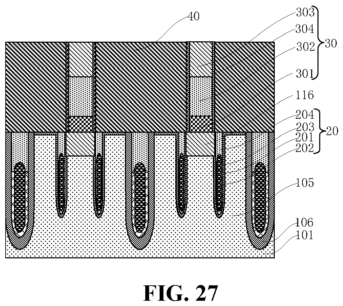

At S44, an insulating isolation layer 40 is filled between adjacent bit line structures 30, as shown in FIG. 27. The insulating isolation layer 40 may include, but is not limited to, a silicon oxide layer, a silicon nitride layer, a silicon oxynitride layer, or the like.

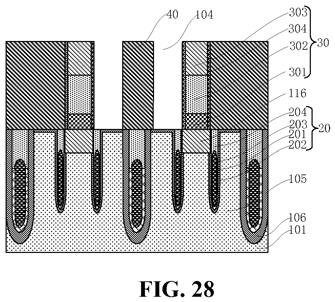

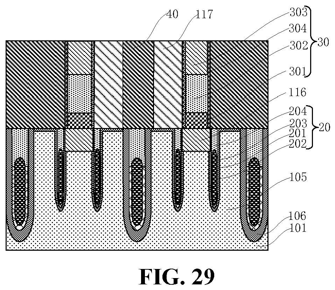

At S45, capacitor storage node contact holes 104 are formed in the insulating isolation layer 40, as shown in FIG. 28. Capacitor storage node contact structures 117 are formed in the capacitor storage node contact holes 104 by the method for manufacturing a semiconductor structure in the embodiments corresponding to FIG. 10 to FIG. 17. The capacitor storage node contact structure 117 is in contact with the active area, as shown in FIG. 29.

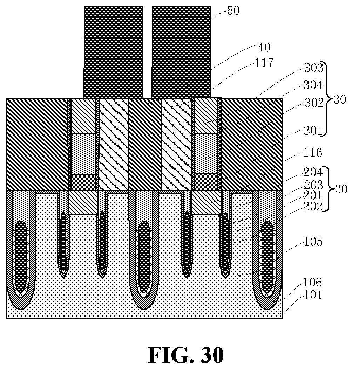

At S46, a capacitor 50 is formed on the insulating isolation layer 40. The capacitor 50 may include a lower electrode (not shown), a capacitive dielectric layer (not shown) located on a surface of the lower electrode, and an upper electrode (not shown). The lower electrode is in contact with the capacitor storage node contact structure 117, as shown in FIG. 30.

In the method for manufacturing a storage device structure of the above-mentioned embodiments, when the conducting material layer is deposited to fill the bit line contact hole 103 , the bit line contact hole 103 is filled up by performing the multiple conducting material layer deposition processes instead of one-time deposition process, and the deposited conducting material layer is annealed after at least some of the conducting material layer deposition processes, so that the conducting material layer can fill up the bit line contact hole 103 without a void. That is, the bit line contact structure 116 without a void can be obtained, thereby reducing a contact resistance of the bit line contact structure 116 and thus improving a yield of storage device structures.

In the method for manufacturing a storage device structure of the above-mentioned embodiments, when the conducting material layer is deposited to fill the capacitor storage node contact hole 104, the capacitor storage node contact hole 104 is filled up by performing the multiple conducting material layer deposition processes instead of one-time deposition process, and the deposited conducting material layer is annealed after at least some of the conducting material layer deposition processes, so that the conducting material layer can fill up the capacitor storage node contact hole 104 without a void. That is, the capacitor storage node contact structure 117 without a void can be obtained, thereby reducing a contact resistance of the capacitor storage node contact structure 117 and thus improving a yield of storage device structures.

It should be understood that, unless explicitly stated herein, the steps described are not strictly limited to the order in which they are performed, and that the steps may be performed in other orders. Moreover, one of at least a part of the described steps may include multiple sub-steps or multiple stages. These sub-steps or stages are not necessarily performed and completed at the same time, and may be performed at different times. The sub-steps or stages not necessarily performed in sequence, but may be performed in turn or alternately with other steps or at least some of sub-steps or stages of the other steps.

In this specification, embodiments are described in a progressive manner, and each embodiment focuses on the differences from other embodiments, so the same and similar parts between the embodiments may be referred to for each other.

The technical features of the above-described embodiments may be arbitrarily combined. For the simplicity of the illustration, not all possible combinations of the technical features of the above-described embodiments have been described. However, as long as there is no contradiction in the combinations of these technical features, they should be considered as being in the scope described in this specification.

The above-described embodiments are merely illustrative of several implementations of the embodiments of the disclosure, and the description thereof is more specific and detailed, but cannot therefore be construed as a limitation on the scope of the patent application. It should be noted that, for an ordinary person skilled in the art, a number of modifications and improvements can be made without departing from the concept of the embodiments of the disclosure, which fall within the protection scope of the embodiments of the disclosure. Therefore, the protection scope of the disclosure should be subject to the protection scope of the claims.

## Claims

1. A method for manufacturing a semiconductor structure, comprising:
providing a structure to be etched;
forming an etched hole in the structure to be etched;
performing multiple conducting material layer deposition processes until the conducting material layer fills up the etched hole without a void, wherein the method further comprises: after at least some of the conducting material layer deposition processes, annealing the conducting material layer deposited.

2. The method according to claim 1, further comprising: after each of the conducting material layer deposition processes, annealing the conducting material layer deposited.

3. The method according to claim 1, wherein after annealing the conducting material layer, part of the conducting material layer located at a top corner of a sidewall of the etched hole presents a rounded corner shape.

4. The method according to claim 1, wherein the structure to be etched comprises a substrate, and the etched hole comprises a bit line contact hole, and a bit line contact structure is formed after the conducting material layer fills up the etched hole without a void.

5. The method according to claim 1, wherein annealing the conducting material layer deposited after at least some of the conducting material layer deposition processes comprises:
annealing the conducting material layer deposited after an odd-numbered conducting material layer deposition process, or
annealing the conducting material layer deposited after an even-numbered conducting material layer deposition process.

6. The method according to claim 5, wherein during performing the multiple conducting material layer deposition processes, a number of times of annealing the conducting material layer deposited is more than or equal to half of a number of times of depositing the conducting material layer.

7. The method according to claim 1, wherein the structure to be etched comprises a substrate and a dielectric layer located on the substrate, the etched hole penetrates through the dielectric layer in a thickness direction, and a capacitor storage node contact structure is formed after the conducting material layer fills up the etched hole without a void.

8. The method according to claim 1, wherein the conducting material layer comprises a doped polycrystalline silicon layer.

9. The method according to claim 1, a depth-to-width ratio of the etched hole is greater than or equal to 4:1.

10. The method according to any one of claims 1 to 10, wherein the conducting material layer is annealed under an atmosphere comprising hydrogen.

11. The method according to claim 10, wherein the conducting material layer is annealed under an atmosphere of pure hydrogen.

12. The method according to claim 10, wherein the conducting material layer is annealed under an atmosphere of mixed hydrogen and nitrogen.

13. The method according to claim 10, wherein an annealing temperature comprises 700 °C to 1200 °C.

14. The method according to claim 10, wherein an annealing time comprises 30 s to 2 h.

15. The method according to claim 10, wherein an annealing pressure during the annealing comprises 10 Torr to 760 Torr.

16. The method according to claim 10, wherein during annealing the conducting material layer under the atmosphere comprising hydrogen, a gas flow rate of hydrogen is 1 slm to 100 slm.
